# EUROPEAN PATENT APPLICATION

(11) **EP 4 481 815 A1**
(43) Date of publication of application: **25.12.2024**
(21) Application number: 24169787.9
(22) Date of filing: 11.04.2024
(51) Int. Cl.: H01L 25/075, H01L 33/58

(54) **HIDDEN DISPLAY DEVICE AND METHOD OF MANUFACTURING THE SAME**

(30) Priority: 19.06.2023 US 202363521756 P
(71) Applicant: Asti Global Inc., Taiwan, 406 Taichung City (TW)
(72) Inventor: CHEN, YING-CHIEH, 406 Taichung City (TW); LIAO, CHIEN-SHOU, 406 Taichung City (TW)
(74) Representative: Wunderlich & Heim Patentanwälte PartG mbB

(57) **Abstract**

A hidden display device (P) and a method of manufacturing the same are provided. The hidden display device (P) includes an appearance decorative structure (1), a light-emitting module (2) and a signal control module (3). The appearance decorative structure (1) includes an appearance decorative shell (11). The light-emitting module (2) is covered by the appearance decorative structure (1). The appearance decorative shell (11) has a plurality of micron-level through openings (110) each having a maximum diameter (D) between 5 µm and 200 µm. The minimum distance (G) between any two adjacent micron-level through openings (110) is between 50 µm and 100 µm. The light-emitting module (2) includes a plurality of light-emitting units (22) respectively correspond to the micron-level through openings (110). When the signal control module (3) is configured to control the light-emitting units (22) to provide a predetermined image (M) or a predetermined light source (L), the predetermined image (M) or the predetermined light source (L) is presented on the appearance decorative shell (11) through the micron-level through openings (110).

## Description

### FIELD OF THE INVENTION

The present invention relates to a display device and a method of manufacturing the same, and more particularly to a hidden display device and a method of manufacturing the same.

### BACKGROUND OF THE INVENTION

In the related art, whether it is a recessed lighting lamp or a recessed display device, a receiving area is first formed on the outer shell or decorative panel, and then the recessed lighting lamp or the recessed display device is installed in the receiving area, so that users can easily detect the position of the recessed lighting lamp or the recessed display device, resulting in the outer shell or the decorative panel not being able to provide a continuous and complete appearance.

### SUMMARY OF THE INVENTION

In response to the above-referenced technical inadequacy, the present invention provides a hidden display device and a method of manufacturing the same. When the signal control module is configured to completely turn off the light-emitting units, a user cannot identify the micron-level through openings of the appearance decorative shell with his or her naked eyes, so that the appearance decorative shell is presented to the user in a hole-free appearance.

In order to solve the above-mentioned problems, one of the technical aspects adopted by the present invention is to provide a hidden display device, which includes an appearance decorative structure, a light-emitting module and a signal control module. The appearance decorative structure includes an appearance decorative shell and a transparent protective layer disposed on the appearance decorative shell. The light-emitting module is covered by the appearance decorative structure. The signal control module is electrically connected to the light-emitting module. The appearance decorative shell has a plurality of micron-level through openings arranged in a predetermined shape, and the micron-level through openings are covered by the transparent protective layer. A maximum diameter of each of the micron-level through openings is between 5 µm and 200 µm, and a minimum distance between any two adjacent ones of the micron-level through openings is between 50 µm and 100 µm. The light-emitting module has a flexible substrate and a plurality of light-emitting units, the flexible substrate is configured to conform to an appearance of the appearance decorative shell, and the light-emitting units are disposed on the flexible substrate and electrically connected to the flexible substrate. The light-emitting units are configured to be arranged in a predetermined shape and respectively correspond to the micron-level through openings, and the signal control module is configured to turn off or on each of the light-emitting units. When the signal control module is configured to completely turn off the light-emitting units, a user cannot identify the micron-level through openings of the appearance decorative shell with his or her naked eyes, so that the appearance decorative shell is presented to the user in a hole-free appearance. When the signal control module is configured to control the light-emitting units to provide a predetermined image, the predetermined image provided by the light-emitting units is presented on the appearance decorative shell through the micron-level through openings. When the signal control module is configured to control the light-emitting units to provide a predetermined light source, the predetermined light source provided by the light-emitting units is presented on the appearance decorative shell through the micron-level through openings.

In order to solve the above-mentioned problems, another one of the technical aspects adopted by the present invention is to provide a hidden display device, which includes an appearance decorative structure, a light-emitting module and a signal control module. The appearance decorative structure includes an appearance decorative shell. The light-emitting module is covered by the appearance decorative structure. The signal control module is electrically connected to the light-emitting module. The appearance decorative shell has a plurality of micron-level through openings arranged in a predetermined shape. A maximum diameter of each of the micron-level through openings is between 5 µm and 200 µm, and a minimum distance between any two adjacent ones of the micron-level through openings is between 50 µm and 100 µm. The light-emitting module includes a plurality of light-emitting units, and the light-emitting units are configured to be arranged in a predetermined shape and respectively correspond to the micron-level through openings. When the signal control module is configured to control the light-emitting units to provide a predetermined image, the predetermined image provided by the light-emitting units is presented on the appearance decorative shell through the micron-level through openings. When the signal control module is configured to control the light-emitting units to provide a predetermined light source, the predetermined light source provided by the light-emitting units is presented on the appearance decorative shell through the micron-level through openings.

In order to solve the above-mentioned problems, yet another one of the technical aspects adopted by the present invention is to provide a method of manufacturing a hidden display device, which includes providing an appearance decorative structure including an appearance decorative shell, wherein the appearance decorative shell has a plurality of micron-level through openings arranged in a predetermined shape; providing a light-emitting module includes a plurality of light-emitting units arranged in a predetermined shape, wherein the light-emitting module is electrically connected to a signal control module; installing the light-emitting module inside the appearance decorative structure so as to cover the light-emitting module through the appearance decorative structure; and then performing an alignment step so as to respectively align the light-emitting units with the micron-level through openings. A maximum diameter of each of the micron-level through openings is between 5 µm and 200 µm, and a minimum distance between any two adjacent ones of the micron-level through openings is between 50 µm and 100 µm. When the signal control module is configured to control the light-emitting units to provide a predetermined image, the predetermined image provided by the light-emitting units is presented on the appearance decorative shell through the micron-level through openings. When the signal control module is configured to control the light-emitting units to provide a predetermined light source, the predetermined light source provided by the light-emitting units is presented on the appearance decorative shell through the micron-level through openings.

Therefore, in the hidden display device provided by the present invention, by virtue of "the appearance decorative shell having a plurality of micron-level through openings arranged in a predetermined shape," "the light-emitting units being configured to be arranged in a predetermined shape and respectively corresponding to the micron-level through openings" and "a maximum diameter of each of the micron-level through openings being between 5 µm and 200 µm, and a minimum distance between any two adjacent ones of the micron-level through openings being between 50 µm and 100 µm," when the signal control module is configured to control the light-emitting units to provide a predetermined image, the predetermined image provided by the light-emitting units can be presented on the appearance decorative shell through the micron-level through openings; or alternatively, when the signal control module is configured to control the light-emitting units to provide a predetermined light source, the predetermined light source provided by the light-emitting units can be presented on the appearance decorative shell through the micron-level through openings.

Furthermore, in the method of manufacturing a hidden display device provided by the present invention, by virtue of "providing an appearance decorative structure including an appearance decorative shell that has a plurality of micron-level through openings arranged in a predetermined shape," "providing a light-emitting module includes a plurality of light-emitting units arranged in a predetermined shape," "installing the light-emitting module inside the appearance decorative structure so as to cover the light-emitting module through the appearance decorative structure," "performing an alignment step so as to respectively align the light-emitting units with the micron-level through openings" and "a maximum diameter of each of the micron-level through openings being between 5 µm and 200 µm, and a minimum distance between any two adjacent ones of the micron-level through openings being between 50 µm and 100 µm," when the signal control module is configured to control the light-emitting units to provide a predetermined image, the predetermined image provided by the light-emitting units can be presented on the appearance decorative shell through the micron-level through openings; or alternatively, when the signal control module is configured to control the light-emitting units to provide a predetermined light source, the predetermined light source provided by the light-emitting units can be presented on the appearance decorative shell through the micron-level through openings.

It should be noted that when the signal control module is configured to completely turn off the light-emitting units, a user cannot identify the micron-level through openings of the appearance decorative shell with his or her naked eyes, so that the appearance decorative shell can be presented to the user in a hole-free appearance in order to achieve the purpose of providing the hidden display device of the present invention (that is to say, when the hidden display device is turned off and not in use, appearance decorative structure can be configured to cover the light-emitting module that is composed of the light-emitting units so as to achieve the purpose of hiding the light-emitting module).

These and other aspects of the present invention will become apparent from the following description of the embodiment taken in conjunction with the following drawings and their captions, although variations and modifications therein may be affected without departing from the spirit and scope of the novel concepts of the invention.

### BRIEF DESCRIPTION OF THE DRAWINGS

The described embodiments may be better understood by reference to the following description and the accompanying drawings, in which:
FIG. 1 is a flowchart of a method of manufacturing a hidden display device provided by the present invention;
FIG. 2 is a schematic exploded view of a hidden display device provided by the first embodiment of the present invention;
FIG. 3 is a schematic assembled view of the hidden display device provided by the first embodiment of the present invention;
FIG. 4 is a schematic assembled view of another hidden display device provided by the first embodiment of the present invention;
FIG. 5 is a schematic view of the hidden display device provided by the first embodiment of the present invention applied in an interior of a car (before turning on a light-emitting module);
FIG. 6 is a schematic view of the hidden display device provided by the first embodiment of the present invention applied in the interior of the car (after turning on the light-emitting module);
FIG. 7 is a schematic view of the hidden display device provided by the first embodiment of the present invention applied to an exterior of the car (before turning on the light-emitting module);
FIG. 8 is a schematic view of the hidden display device provided by the first embodiment of the present invention applied to the exterior of the car (after turning on the light-emitting module);
FIG. 9 is a schematic assembled view of one of the hidden display devices provided by the second embodiment of the present invention;
FIG. 10 is a schematic assembled view of one of the hidden display devices provided by the third embodiment of the present invention; and
FIG. 11 is a schematic assembled view of one of the hidden display devices provided by the fourth embodiment of the present invention.

### DETAILED DESCRIPTION OF THE EXEMPLARY EMBODIMENTS

The present invention is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" includes plural reference, and the meaning of "in" includes "in" and "on." Titles or subtitles can be used herein for the convenience of a reader, which shall have no influence on the scope of the present invention.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present invention or of any exemplified term. Likewise, the present invention is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

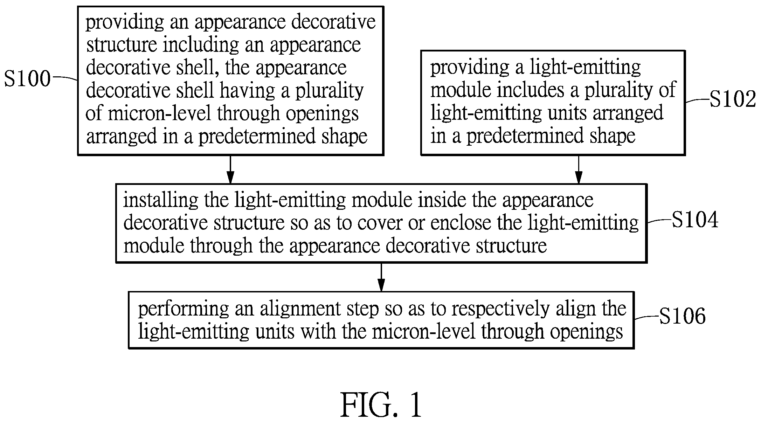

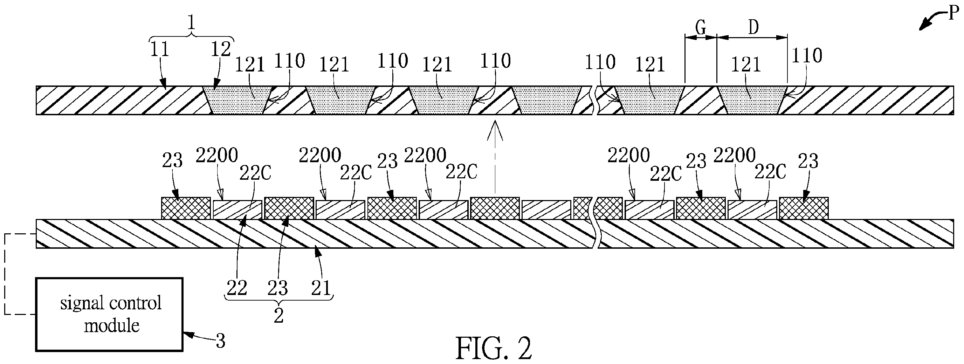

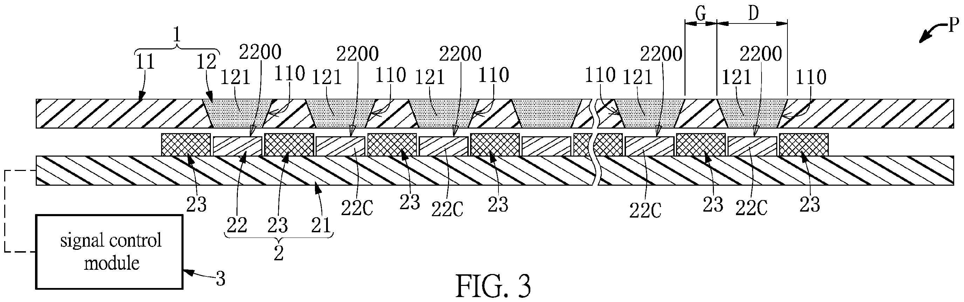

Referring to FIG. 1 to FIG. 8, the present invention provides a method of manufacturing a hidden display device P, which may at least include: referring to FIG. 1 and FIG. 2, providing an appearance decorative structure 1 including an appearance decorative shell 11, in which the appearance decorative shell 11 has a plurality of micron-level through openings 110 arranged in a predetermined shape (step S100); next, referring to FIG. 1 and FIG. 2, providing a light-emitting module 2 includes a plurality of light-emitting units 22 arranged in a predetermined shape (step S102); then, referring to FIG. 1 and FIG. 3, installing the light-emitting module 2 inside the appearance decorative structure 1 so as to cover or enclose the light-emitting module 2 through the appearance decorative structure 1 (step S104); afterward, referring to FIG. 1 and FIG. 3, performing an alignment step so as to respectively align the light-emitting units 22 with the micron-level through openings 110 (step S106). It should be noted that each of the micron-level through openings 110 has a maximum diameter D (or a maximum width) between 5 µm and 200 µm (or any positive integer less than 5 µm, or any positive integer greater than 200 µm, or any positive integer between 1 µm and 1000 µm), and a minimum distance G (or a minimum spacing) between any two adjacent ones of the micron-level through openings 110 is between 50 µm and 100 µm (or any positive integer less than 50 µm, or any positive integer greater than 100 µm, or any positive integer between 50 µm and 100 µm).

For example, in the step S100 of providing the appearance decorative structure 1 (or the exterior decoration structure 1), designing a predetermined shape in advance in which the micron-level through openings 110 need to be arranged, and then forming a plurality of micron-level through openings 110 on appearance decorative shell 11 (or the exterior decoration housing 11) through laser processing or any other processing method according to the predetermined shape that can be designed in advance. In addition, in the step S106 of performing the alignment step, the light-emitting units 22 can accurately correspond to the micron-level through an optical alignment method or an optical alignment device, so that the projection light sources generated by the light-emitting units 22 can pass through the micron-level through openings 110 respectively (for example, an image capturing system can be used to determine whether the projection light sources generated by the light-emitting units 22 accurately pass through the micron-level through openings 110 respectively). It should be noted that the light-emitting module 2 can be an LCD display, an OLED display, a mini-LED display, a micro-LED display, or any kind of image display, so that the light-emitting units 22 can be an LCD panel, an OLED panel, a plurality of mini LED chips, a plurality of micro LED chips, or any kind of light-emitting chips. However, the aforementioned details are disclosed for exemplary purposes only.

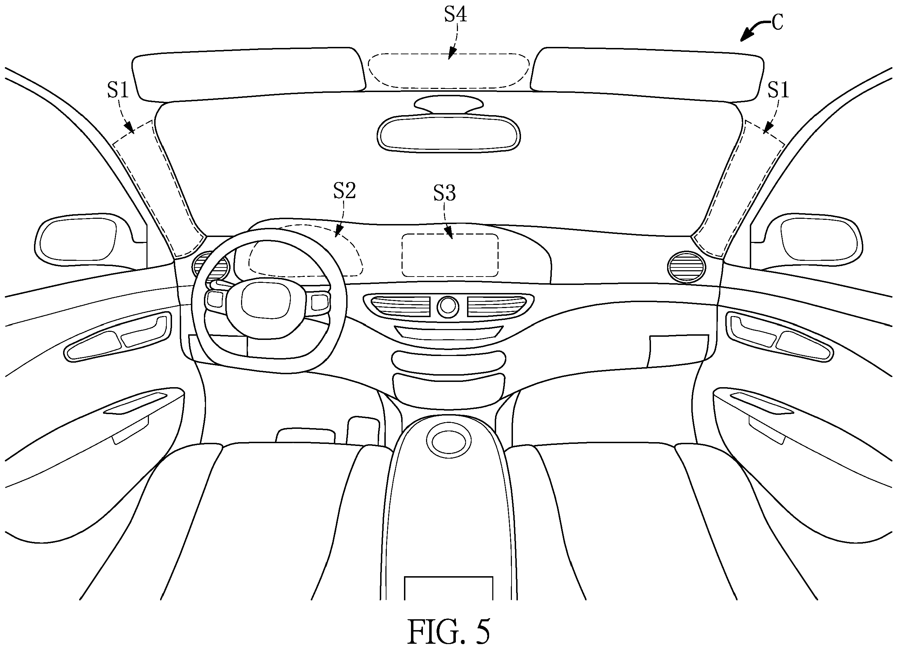

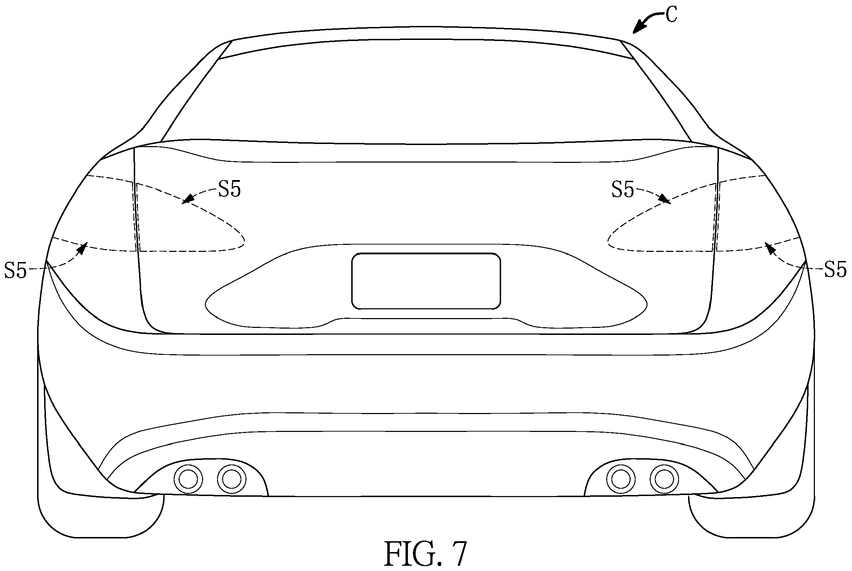

Therefore, referring to FIG. 5 or FIG. 7, when the signal control module 3 is configured to completely turn off the light-emitting units 22, the light-emitting module 2 has been covered by the appearance decorative structure 1, and a user (or a driver) cannot identify (or detect or notice) the micron-level through openings 110 of the appearance decorative shell 11 with his or her naked eyes due to the limitation of human visual ability (or recognition ability), so that the appearance decorative shell 11 can be presented to the user (or the driver) in a hole-free appearance (that is to say, when the light-emitting units 22 are completely turned off, the user (or the driver) can only observe the appearance decorative shell 11 without any holes through his or her naked eyes, thereby achieving the purpose of hiding the light-emitting module 2).

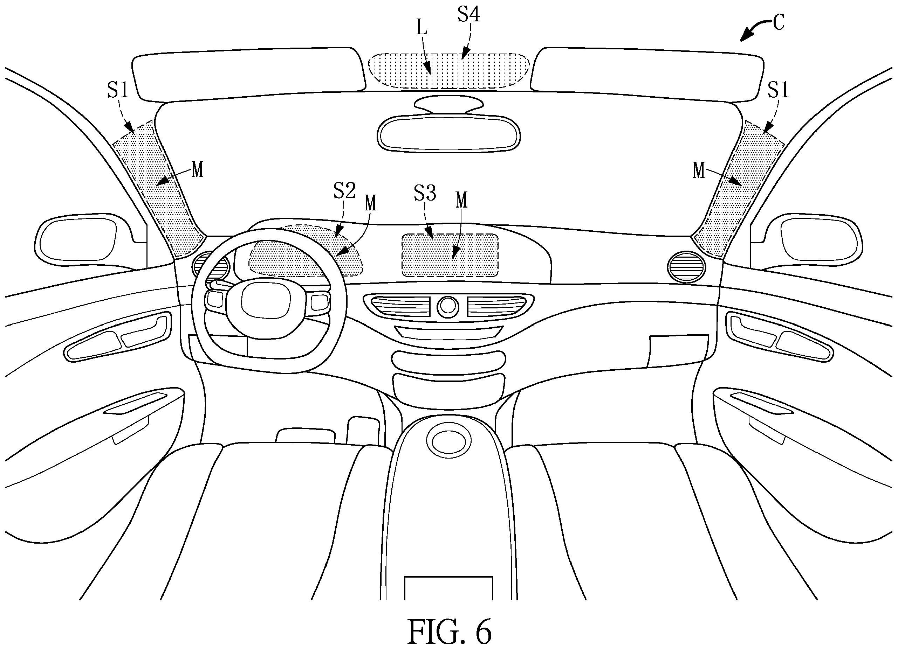

More particularly, as shown in FIG. 6, when the signal control module 3 is configured to control the light-emitting units 22 to provide a predetermined image M (such as any moving image or still image), the predetermined image M provided by the light-emitting units 22 can be presented on the appearance decorative shell 11 through the micron-level through openings 110 (that is to say, when the light-emitting units 22 cooperate with each other to provide a predetermined image M, the micron-level through openings 110 respectively correspond to the light-emitting units 22, so that the user can view or see the predetermined image M presented on the appearance decorative shell 11 only with the naked eye). It should be noted that the predetermined image M can be generated by the light-emitting units 22 that are turned on sequentially (or sequentially lighting up) within a predetermined period (or a predetermined time). That is to say, the light-emitting units 22 configured to provide the predetermined image M will not be turned on at the same time, thereby saving power and improving the heat dissipation effect.

More particularly, as shown in FIG. 6, when the signal control module 3 is configured to control the light-emitting units 22 to provide a predetermined light source L (such as a yellow light source, a red light source, a white light source or any other color light source), the predetermined light source L provided by the light-emitting units 22 can be presented on the appearance decorative shell 11 through the micron-level through openings 110 (that is to say, when the light-emitting units 22 cooperate with each other to provide a predetermined light source L, the micron-level through openings 110 respectively correspond to the light-emitting units 22, so that the user can view or see the predetermined light source L presented on the appearance decorative shell 11 only with the naked eye). It should be noted that the predetermined light source L can be generated by the light-emitting units 22 that are turned on sequentially (or sequentially lighting up) within a predetermined period (or a predetermined time). That is to say, the light-emitting units 22 configured to provide the predetermined light source L will not be turned on at the same time, thereby saving power and improving the heat dissipation effect.

### [First Embodiment]

Referring to FIG. 3 to FIG. 8, a first embodiment of the present invention provides a hidden display device P, which includes an appearance decorative structure 1, a light-emitting module 2 (or an image display device or a light source providing device) and a signal control module 3. More particularly, the appearance decorative structure 1 includes an appearance decorative shell 11 (or an exterior decoration housing) and a transparent protective layer 12 disposed on the appearance decorative shell 11, the light-emitting module 2 can be covered by the appearance decorative structure 1, and the signal control module 3 is electrically connected to the light-emitting module 2. It is worth noting that, depending on different requirements, the transparent protective layer 12 provided by the first embodiment of the present invention can also be omitted and not used.

For example, as shown in FIG. 3, the appearance decorative shell 11 can be made of any opaque material, such as any opaque material used indoors or any opaque material used in vehicles. Moreover, the appearance decorative shell 11 has a plurality of micron-level through openings 110 (or micron-scale through openings) arranged in a predetermined shape, and the micron-level through openings 110 can be covered by the transparent protective layer 12, or the transparent protective layer 12 can be omitted so that the micron-level through openings 110 can be exposed to the external environment. In addition, a maximum diameter D of each of the micron-level through openings 110 may be approximately between 5 µm and 200 µm, and a minimum distance G (or a minimum spacing) between any two adjacent ones of the micron-level through openings 110 may be approximately between 50 µm and 100 µm. More particularly, each of the micron-level through openings 110 can be a laser penetration hole formed by laser processing (or each micron-level through opening 110 can also be a through hole formed by any other kind of drilling method), the maximum diameter D of each of the micron-level through openings 110 may be between any two positive integers between greater than 5 µm and less than 200 µm (or any positive integer less than 5 µm, or any positive integer greater than 200 µm, or any positive integer between 1 µm and 1000 µm), and the minimum distance G of each of the micron-level through openings 110 between any two adjacent micron-level through openings 110 may be between any two positive integers between greater than 50 µm and less than 100 µm (or any positive integer less than 50 µm, or any positive integer greater than 100 µm). However, the aforementioned details are disclosed for exemplary purposes only.

For example, as shown in FIG. 3, the transparent protective layer 12 can be made of any transparent material, such as any transparent material that can be used indoors or any transparent material that can be used in vehicles. In addition, the transparent protective layer 12 can be disposed in an inner area located within the micron-level through openings 110 of the appearance decorative shell 11 for sealing the micron-level through openings 110. More particularly, when the transparent protective layer 12 is disposed in the inner area located within the micron-level through openings 110 of the appearance decorative shell 11, the transparent protective layer 12 has a plurality of transparent fillers 121 (or transparent filling bodies) separate from each other for respectively filling in the micron-level through openings 110 and completely exposes an outer surface of the appearance decorative shell 11 (that is to say, the outer surface of the appearance decorative shell 11 will not be covered by the transparent fillers 121). However, the aforementioned details are disclosed for exemplary purposes only.

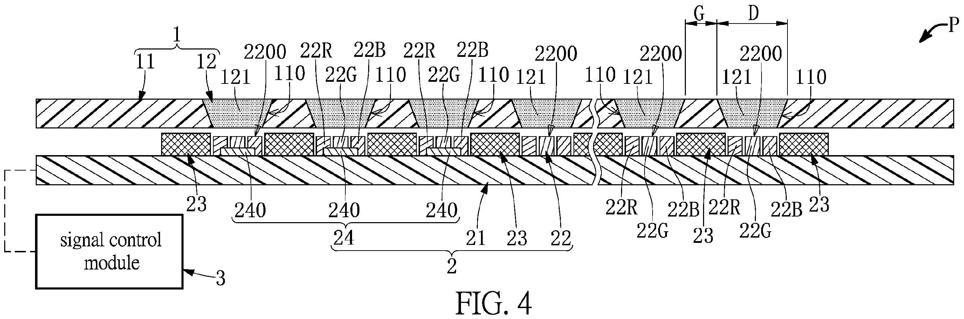

For example, referring to FIG. 3 and FIG. 4, the light-emitting module 2 has a flexible substrate 21 (or a non-flexible substrate) and a plurality of light-emitting units 22, the flexible substrate 21 can be configured (such as being bent) to conform to an appearance of the appearance decorative shell 11, and the light-emitting units 22 can be disposed on the flexible substrate 21 and electrically connected to the flexible substrate 21. Moreover, the light-emitting units 22 can be configured to be arranged in a predetermined shape and respectively correspond to the micron-level through openings 110, and the signal control module 3 can be configured to turn off or turn on each of the light-emitting units 22. In addition, each of the light-emitting units 22 has a light-emitting surface 2200, and the light-emitting surface 2200 of each of the light-emitting units 22 can be disposed outside a corresponding one of the micron-level through openings 110, so that the light-emitting units 22 can be in contact with or not in contact with the appearance decorative shell 11 or the transparent protective layer 12 of the appearance decorative structure 1. It should be noted that the signal control module 3 may include a plurality of microcontrollers (such as CMOS controllers), and the microcontrollers may be disposed on the flexible substrate 21 for controlling the light-emitting units 22 respectively. However, the aforementioned details are disclosed for exemplary purposes only.

For example, referring to FIG. 3 and FIG. 4, each of the light-emitting units 22 includes a micro LED chip 22C (as shown in FIG. 3) or a plurality of micro LED chips (as shown in FIG. 4). More particularly, when each of the light-emitting units 22 includes a micro LED chip 22C, the micro LED chip 22C can generate a specific color light source according to different requirements (for example, using a red micro LED chip, a green micro LED chip or a blue micro LED chip 22B corresponding to a corresponding micron-level through opening 110), or the micro LED chip 22C can also generate a specific color light source through phosphors (for example, a blue micro LED chip can generate a white light source through yellow phosphors). When each of the light-emitting units 22 includes a plurality of micro LED chips, the micro LED chips of each of the light-emitting units 22 include a red micro LED chip 22R for providing a red light source, a green micro LED chip 22G for providing a green light source, and a blue micro LED chip 22B for providing a blue light source, and the red micro LED chip 22R, the green micro LED chip 22G and the blue micro LED chip 22B can cooperate with each other to form an image pixel of the predetermined image M. In addition, the light-emitting module 2 further includes a plurality of opaque structures 23 (i.e., multiple light-shielding structures that can be made of any opaque material), and each of the opaque structures 23 can be disposed between two adjacent ones of the light-emitting units 22 so as to prevent any two adjacent light-emitting units 22 from being affected by crosstalk. However, the aforementioned details are disclosed for exemplary purposes only.

For example, referring to FIG. 5 to FIG. 8, the appearance decorative structure 1 can be applied to an indoor environment or an outdoor environment, and the appearance decorative structure 1 can be applied to an interior or an exterior of a car C. More particularly, when the appearance decorative structure 1 is applied to a car C, the appearance decorative shell 11 can be configured as an exterior shell (i.e., an automotive sheet metal) or an interior decoration (i.e., an automotive decoration) of the car C. However, the aforementioned details are disclosed for exemplary purposes only.

For example, referring to FIG. 5 and FIG. 6, in one possible embodiment, when the appearance decorative shell 11 is configured as the interior shell of the car C, the predetermined image M provided by the light-emitting units 22 can be applied to an A-pillar structure S 1 located inside the car C (for example, there are two A-pillar structure S1 on either side of the windshield) for presenting an external scene located behind the A-pillar structure S 1 on a surface of the A-pillar structure S 1 so as to create a pillar display module for blind spot of vehicle. Therefore, when the light-emitting module 2 is turned on, the driver can see the external image located behind the A-pillar structure S1 (i.e., the driver's field of view blocked by the A-pillar structure S1) through the predetermined image M that can be displayed on the surface of the A-pillar structure S1 (allowing the driver to see through the A-pillar structure S1), thereby achieving the effect that the driver seems to be able to see through the A-pillar structure S1, which helps to solve the visual blind spot problem caused by the A-pillar structure S1 to the driver. However, the aforementioned details are disclosed for exemplary purposes only.

For example, referring to FIG. 5 and FIG. 6, in one possible embodiment, when the appearance decorative shell 11 is configured as the interior decoration of the car C, the predetermined image M provided by the light-emitting units 22 can be applied to an interior of the car C as a vehicle instrument panel S2 (FIG. 5 and FIG. 6 taking two vehicle instrument panels S2 as an example for illustration) configured for providing an information image, thereby providing relevant instrument panel information to the user (in other words, the car C will be able to omit the traditional exposed vehicle instrument panel). However, the aforementioned details are disclosed for exemplary purposes only.

For example, referring to FIG. 5 and FIG. 6, in one possible embodiment, when the appearance decorative shell 11 is configured as the interior decoration of the car C, the predetermined image M provided by the light-emitting units 22 can be applied to the interior of the car C as a vehicle display S3 configured for providing an information image, thereby providing relevant audio and video information to the user (in other words, the car C will be able to omit the traditional exposed car display). It is worth noting that the vehicle display S3 can also be set up anywhere near the back seat of the car to facilitate viewing by back seat passengers. However, the aforementioned details are disclosed for exemplary purposes only.

For example, referring to FIG. 5 and FIG. 6, in one possible embodiment, when the appearance decorative shell 11 is configured as the interior decoration of the car C, the predetermined light source L provided by the light-emitting units 22 can be applied to an interior of the car C as a vehicle lighting lamp S4 configured for providing an illumination light source (in other words, car C will be able to omit the general traditional exposed car lighting). However, the aforementioned details are disclosed for exemplary purposes only.

It should be noted that, for example, in one possible embodiment, when the appearance decorative shell 11 is configured as the exterior shell of the car C, the predetermined image M provided by the light-emitting units 22 can be applied to an exterior of the car C as an advertising billboard (such as dynamic digital signage, a narrowcasting or an electronic billboard installed on the door or body of the car C) for providing an advertising image. However, the aforementioned details are disclosed for exemplary purposes only.

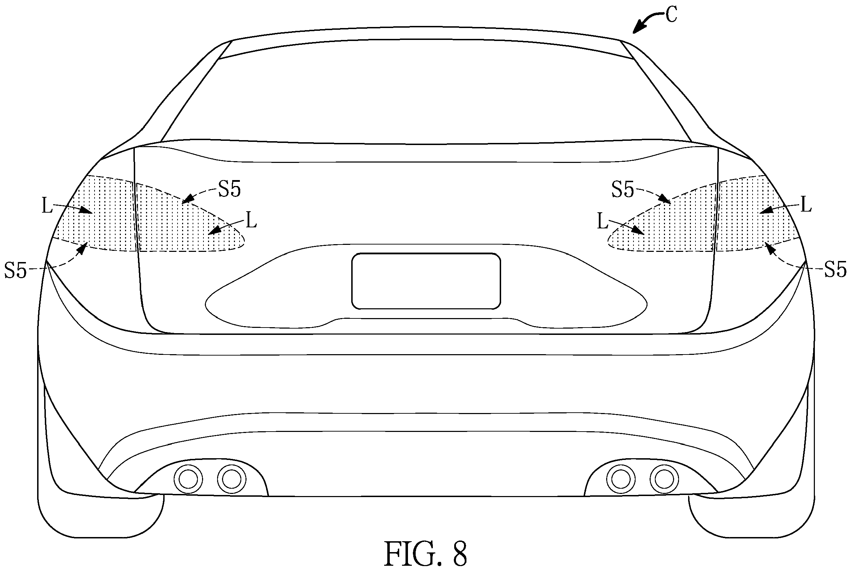

For example, referring to FIG. 7 and FIG. 8, in one possible embodiment, when the appearance decorative shell 11 is configured as the exterior shell of the car C, the predetermined light source L provided by the light-emitting units 22 can be applied to an exterior of the car C as a rear vehicle light S5 (i.e., a reversing light, a brake light, a warning light or a direction light, and FIG. 7 and FIG. 8 taking four rear vehicle lights S5 as an example for illustration) configured for providing a warning light source. However, the aforementioned details are disclosed for exemplary purposes only.

Therefore, referring to FIG. 5 or FIG. 7, when the signal control module 3 is configured to completely turn off the light-emitting units 22, the light-emitting module 2 has been covered by the appearance decorative structure 1, and a user (or a driver) cannot identify (or detect or notice) the micron-level through openings 110 of the appearance decorative shell 11 with his or her naked eyes due to the limitation of human visual ability (or recognition ability), so that the appearance decorative shell 11 can be presented to the user (or the driver) in a hole-free appearance (that is to say, when the light-emitting units 22 are completely turned off, the user (or the driver) can only observe the appearance decorative shell 11 without any holes through his or her naked eyes, thereby achieving the purpose of hiding the light-emitting module 2). More particularly, as shown in FIG. 6, when the signal control module 3 is configured to control the light-emitting units 22 to provide a predetermined image M (such as any moving image or still image), the predetermined image M provided by the light-emitting units 22 can be presented on the appearance decorative shell 11 through the micron-level through openings 110 (that is to say, when the light-emitting units 22 cooperate with each other to provide a predetermined image M, the micron-level through openings 110 respectively correspond to the light-emitting units 22, so that the user can view or see the predetermined image M presented on the appearance decorative shell 11 only with the naked eye). In addition, as shown in FIG. 6 or FIG. 8, when the signal control module 3 is configured to control the light-emitting units 22 to provide a predetermined light source L (such as a yellow light source, a red light source, a white light source or any other color light source), the predetermined light source L provided by the light-emitting units 22 can be presented on the appearance decorative shell 11 through the micron-level through openings 110 (that is to say, when the light-emitting units 22 cooperate with each other to provide a predetermined light source L, the micron-level through openings 110 respectively correspond to the light-emitting units 22, so that the user can view or see the predetermined light source L presented on the appearance decorative shell 11 only with the naked eye).

It should be noted that, for example, as shown in FIG. 4, the hidden display device P further includes a light sensing module 24 including a plurality of light sensing elements 240 (such as light sensors or fingerprint sensors) electrically connected to the signal control module 3, and the light sensing elements 240 can respectively correspond to all of the light-emitting units 22 or respectively correspond to some of the light-emitting units 22 (that is to say, a part of the light sensing elements 240 respectively corresponds to a part of the light-emitting units 22), for identifying a fingerprint image of the user (that is to say, the A-pillar structure S 1, the vehicle instrument panel S2, the vehicle display S3, the vehicle lighting lamp S4 and the rear vehicle light S5 can be equipped with a fingerprint recognition function). However, the aforementioned details are disclosed for exemplary purposes only.

### [Second Embodiment]

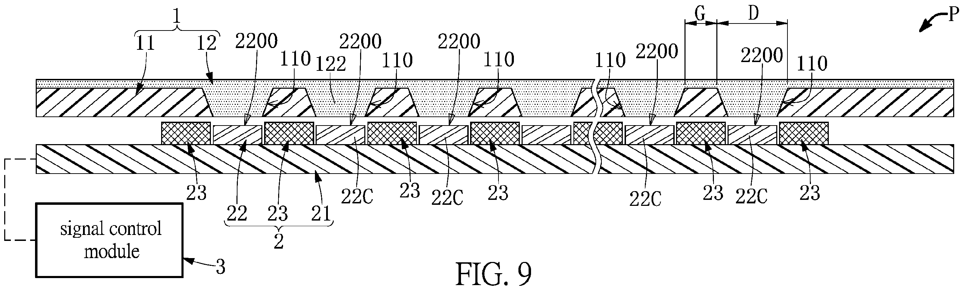

Referring to FIG. 9, a second embodiment of the present invention provides a hidden display device P, which includes an appearance decorative structure 1, a light-emitting module 2 (or an image display device or a light source providing device) and a signal control module 3. Comparing FIG. 9 with FIG. 3, the main difference between the second embodiment and the first embodiment is as follows: in the second embodiment, the transparent protective layer 12 can also be provided by an inner area located within the micron-level through openings 110 of the appearance decorative shell 11 and an outer area outside the micron-level through openings 110 of the appearance decorative shell 11 (or the transparent protective layer 12 can also be provided only in an outer area outside the micron-level through openings 110 of the appearance decorative shell 11), for sealing the micron-level through openings 110. More particularly, the transparent protective layer 12 is provided by the inner area located within the micron-level through openings 110 of the appearance decorative shell 11 and the outer area outside the micron-level through openings 110 of the appearance decorative shell 11, the transparent protective layer 12 has a transparent covering body 122 (or a continuous and single transparent covering body) for completely covering the micron-level through openings 110 and the appearance decorative shell 11 (that is to say, the outer surface of the appearance decorative shell 11 will be completely covered by the transparent fillers 121).

### [Third Embodiment]

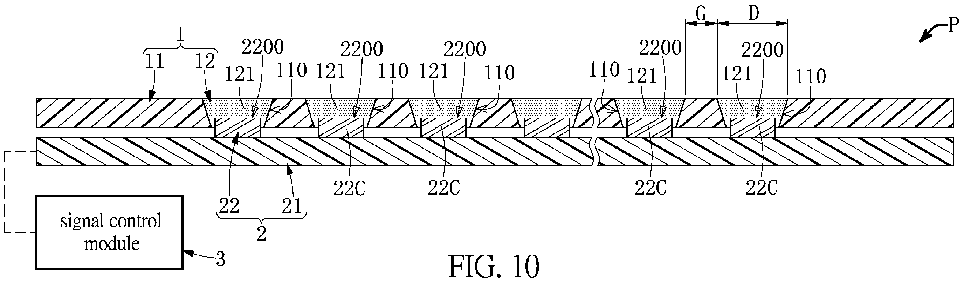

Referring to FIG. 10, a third embodiment of the present invention provides a hidden display device P, which includes an appearance decorative structure 1, a light-emitting module 2 (or an image display device or a light source providing device) and a signal control module 3. Comparing FIG. 10 with FIG. 3, the main difference between the third embodiment and the first embodiment is as follows: in the third embodiment, the light-emitting surface 2200 of each of the light-emitting units 22 can be disposed inside a corresponding one of the micron-level through openings 110, so that the light-emitting surface 2200 of each light-emitting unit 22 can contact the transparent protective layer 12 or be away from the transparent protective layer 12.

### [Fourth Embodiment]

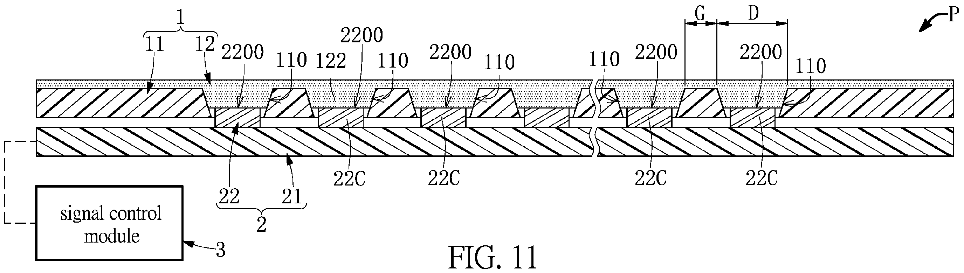

Referring to FIG. 11, a fourth embodiment of the present invention provides a hidden display device P, which includes an appearance decorative structure 1, a light-emitting module 2 (or an image display device or a light source providing device) and a signal control module 3. Comparing FIG. 11 with FIG. 10, the main difference between the fourth embodiment and the third embodiment is as follows: in the fourth embodiment, the transparent protective layer 12 can also be provided by an inner area located within the micron-level through openings 110 of the appearance decorative shell 11 and an outer area outside the micron-level through openings 110 of the appearance decorative shell 11 (or the transparent protective layer 12 can also be provided only in an outer area outside the micron-level through openings 110 of the appearance decorative shell 11), for sealing the micron-level through openings 110. More particularly, the transparent protective layer 12 is provided by the inner area located within the micron-level through openings 110 of the appearance decorative shell 11 and the outer area outside the micron-level through openings 110 of the appearance decorative shell 11, the transparent protective layer 12 has a transparent covering body 122 (or a continuous and single transparent covering body) for completely covering the micron-level through openings 110 and the appearance decorative shell 11 (that is to say, the outer surface of the appearance decorative shell 11 will be completely covered by the transparent fillers 121).

### [Beneficial Effects of the Embodiments]

In conclusion, in the hidden display device P provided by the present invention, by virtue of "the appearance decorative shell 11 having a plurality of micron-level through openings 110 arranged in a predetermined shape," "the light-emitting units 22 being configured to be arranged in a predetermined shape and respectively corresponding to the micron-level through openings 110" and "a maximum diameter D of each of the micron-level through openings 110 being between 5 µm and 200 µm, and a minimum distance G between any two adjacent ones of the micron-level through openings 110 being between 50 µm and 100 µm," when the signal control module 3 is configured to control the light-emitting units 22 to provide a predetermined image M, the predetermined image M provided by the light-emitting units 22 can be presented on the appearance decorative shell 11 through the micron-level through openings 110; or alternatively, when the signal control module 3 is configured to control the light-emitting units 22 to provide a predetermined light source L, the predetermined light source L provided by the light-emitting units 22 can be presented on the appearance decorative shell 11 through the micron-level through openings 110.

Furthermore, in the method of manufacturing a hidden display device P provided by the present invention, by virtue of "providing an appearance decorative structure 1 including an appearance decorative shell 11 that has a plurality of micron-level through openings 110 arranged in a predetermined shape," "providing a light-emitting module 2 includes a plurality of light-emitting units 22 arranged in a predetermined shape," "installing the light-emitting module 2 inside the appearance decorative structure 1 so as to cover the light-emitting module 2 through the appearance decorative structure," "performing an alignment step so as to respectively align the light-emitting units 22 with the micron-level through openings 110" and "a maximum diameter D of each of the micron-level through openings 110 being between 5 µm and 200 µm, and a minimum distance G between any two adjacent ones of the micron-level through openings 110 being between 50 µm and 100 µm," when the signal control module 3 is configured to control the light-emitting units 22 to provide a predetermined image M, the predetermined image M provided by the light-emitting units 22 can be presented on the appearance decorative shell 11 through the micron-level through openings 110; or alternatively, when the signal control module 3 is configured to control the light-emitting units 22 to provide a predetermined light source L, the predetermined light source L provided by the light-emitting units 22 can be presented on the appearance decorative shell 11 through the micron-level through openings 110.

It should be noted that when the signal control module 3 is configured to completely turn off the light-emitting units 22, a user cannot identify the micron-level through openings 110 of the appearance decorative shell 11 with his or her naked eyes, so that the appearance decorative shell 11 can be presented to the user in a hole-free appearance in order to achieve the purpose of providing the hidden display device P of the present invention (that is to say, when the hidden display device P is turned off and not in use, appearance decorative structure can be configured to cover the light-emitting module 2 that is composed of the light-emitting units 22 so as to achieve the purpose of hiding the light-emitting module 2).

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to enable others skilled in the art to utilize the invention and various embodiments and with various modifications as are suited to the particular use contemplated. Alternative embodiments will become apparent to those skilled in the art to which the present invention pertains without departing from its spirit and scope.

## Claims

1. A hidden display device (P), **characterized by** comprising:
an appearance decorative structure (1) including an appearance decorative shell (11);
a light-emitting module (2) being covered by the appearance decorative structure (1); and
a signal control module (3) being electrically connected to the light-emitting module (2);
wherein the appearance decorative shell (11) has a plurality of micron-level through openings (110) arranged in a predetermined shape;
wherein a maximum diameter (D) of each of the micron-level through openings (110) is between 5 µm and 200 µm, and a minimum distance (G) between any two adjacent ones of the micron-level through openings (110) is between 50 µm and 100 µm;
wherein the light-emitting module (2) has a plurality of light-emitting units (22), the light-emitting units (22) are configured to be arranged in a predetermined shape and respectively correspond to the micron-level through openings (110), and the signal control module (3) is configured to turn off or on each of the light-emitting units (22).

2. The hidden display device (P) according to claim 1,
wherein, when the signal control module (3) is configured to control the light-emitting units (22) to provide a predetermined image (M) or a predetermined light source (L), the predetermined image (M) or the predetermined light source (L) provided by the light-emitting units (22) is presented on the appearance decorative shell (11) through the micron-level through openings (110);
wherein the appearance decorative structure (1) is applied to an indoor environment or an outdoor environment, and the appearance decorative structure (1) is applied to an interior or an exterior of a car (C);
wherein, each of the micron-level through openings (110) is a laser penetration hole formed by laser processing, and the maximum diameter (D) of each of the micron-level through openings (110) is between any two positive integers between greater than 5 µm and less than 200 µm, and the minimum distance (G) of each of the micron-level through openings (110) between any two adjacent micron-level through openings (110) is between any two positive integers between greater than 50 µm and less than 100 µm;
wherein the light-emitting units (22) are in contact with or not in contact with the appearance decorative structure (1), and each of the light-emitting units (22) includes a micro LED chip (22C) or a plurality of micro LED chips (22C);
wherein, when each of the light-emitting units (22) includes the micro LED chips (22C), the micro LED chips (22C) of each of the light-emitting units (22) include a red micro LED chip (22R) for providing a red light source, a green micro LED chip (22G) for providing a green light source, and a blue micro LED chip (22B) for providing a blue light source, and the red micro LED chip (22R), the green micro LED chip (22G) and the blue micro LED chip (22B) cooperate with each other to form an image pixel of the predetermined image (M);
wherein each of the light-emitting units (22) has a light-emitting surface (2200), and the light-emitting surface (2200) of each of the light-emitting units (22) is disposed inside or outside a corresponding one of the micron-level through openings (110);
wherein the light-emitting module (2) includes a plurality of opaque structures (23), and each of the opaque structures (23) is disposed between two adjacent ones of the light-emitting units (22);
wherein the hidden display device (P) further includes a light sensing module (24) including a plurality of light sensing elements (240) electrically connected to the signal control module (3), and the light sensing elements (240) respectively correspond to the light-emitting units (22) or respectively correspond to some of the light-emitting units (22), for identifying a fingerprint image of the user;
wherein the predetermined image (M) or the predetermined light source (L) is generated by the light-emitting units (22) that are turned on sequentially within a predetermined period.

3. The hidden display device (P) according to claim 1,
wherein, when the signal control module (3) is configured to control the light-emitting units (22) to provide a predetermined image (M) or a predetermined light source (L), the predetermined image (M) or the predetermined light source (L) provided by the light-emitting units (22) is presented on the appearance decorative shell (11) through the micron-level through openings (110);
wherein the appearance decorative shell (11) is configured as an exterior shell or an interior decoration of a car (C);
wherein, when the appearance decorative shell (11) is configured as the exterior shell of the car (C), the predetermined light source (L) provided by the light-emitting units (22) is applied to an exterior of the car (C) as a rear vehicle light (S5) configured for providing a warning light source;
wherein, when the appearance decorative shell (11) is configured as the interior decoration of the car (C), the predetermined light source (L) provided by the light-emitting units (22) is applied to an interior of the car (C) as a vehicle lighting lamp (S4) configured for providing an illumination light source;
wherein the predetermined image (M) or the predetermined light source (L) is generated by the light-emitting units (22) that are turned on sequentially within a predetermined period.

4. The hidden display device (P) according to claim 3,
wherein the appearance decorative structure (1) includes a transparent protective layer (12) disposed on the appearance decorative shell (11);
wherein the transparent protective layer (12) is disposed in at least one of an inner area located within the micron-level through openings (110) of the appearance decorative shell (11) and an outer area outside the micron-level through openings (110) of the appearance decorative shell (11), for sealing the micron-level through openings (110);
wherein, when the transparent protective layer (12) is disposed in the inner area located within the micron-level through openings (110) of the appearance decorative shell (11), the transparent protective layer (12) has a plurality of transparent fillers (121) separate from each other for respectively filling in the micron-level through openings (110) and completely exposes an outer surface of the appearance decorative shell (11);
wherein, when the transparent protective layer (12) is disposed in the outer area outside the micron-level through openings (110) of the appearance decorative shell (11), the transparent protective layer (12) has a transparent covering body (122) for completely covering the micron-level through openings (110) and the appearance decorative shell (11).

5. The hidden display device (P) according to claim 1,
wherein, when the signal control module (3) is configured to control the light-emitting units (22) to provide a predetermined image (M) or a predetermined light source (L), the predetermined image (M) or the predetermined light source (L) provided by the light-emitting units (22) is presented on the appearance decorative shell (11) through the micron-level through openings (110);
wherein the appearance decorative shell (11) is configured as an exterior shell or an interior decoration of a car (C);
wherein, when the appearance decorative shell (11) is configured as the interior shell of the car (C), the predetermined image (M) provided by the light-emitting units (22) is applied to an A-pillar structure (S 1) located inside the car (C) for presenting an external scene located behind the A-pillar structure (S 1) on a surface of the A-pillar structure (S1);
wherein, when the appearance decorative shell (11) is configured as the interior decoration of the car (C), the predetermined image (M) provided by the light-emitting units (22) is applied to an interior of the car (C) as a vehicle instrument panel (S2) configured for providing an information image, thereby providing relevant instrument panel information to the user;
wherein, when the appearance decorative shell (11) is configured as the interior decoration of the car (C), the predetermined image (M) provided by the light-emitting units (22) is applied to the interior of the car (C) as a vehicle display (S3) configured for providing an information image, thereby providing relevant audio and video information to the user;
wherein the predetermined image (M) or the predetermined light source (L) is generated by the light-emitting units (22) that are turned on sequentially within a predetermined period.

6. The hidden display device (P) according to claim 5,
wherein the appearance decorative structure (1) includes a transparent protective layer (12) disposed on the appearance decorative shell (11);
wherein the transparent protective layer (12) is disposed in at least one of an inner area located within the micron-level through openings (110) of the appearance decorative shell (11) and an outer area outside the micron-level through openings (110) of the appearance decorative shell (11), for sealing the micron-level through openings (110);
wherein, when the transparent protective layer (12) is disposed in the inner area located within the micron-level through openings (110) of the appearance decorative shell (11), the transparent protective layer (12) has a plurality of transparent fillers (121) separate from each other for respectively filling in the micron-level through openings (110) and completely exposes an outer surface of the appearance decorative shell (11);
wherein, when the transparent protective layer (12) is disposed in the outer area outside the micron-level through openings (110) of the appearance decorative shell (11), the transparent protective layer (12) has a transparent covering body (122) for completely covering the micron-level through openings (110) and the appearance decorative shell (11).

7. The hidden display device (P) according to claim 1,
wherein the appearance decorative structure (1) includes a transparent protective layer (12) disposed on the appearance decorative shell (11);
wherein the micron-level through openings (110) are covered by the transparent protective layer (12);
wherein the light-emitting module (2) has a flexible substrate (21) configured to conform to an appearance of the appearance decorative shell (11), and the light-emitting units (22) are disposed on the flexible substrate (21) and electrically connected to the flexible substrate (21).

8. The hidden display device (P) according to claim 1,
wherein, when the signal control module (3) is configured to completely turn off the light-emitting units (22), a user cannot identify the micron-level through openings (110) of the appearance decorative shell (11) with his or her naked eyes, so that the appearance decorative shell (11) is presented to the user in a hole-free appearance;
wherein, when the signal control module (3) is configured to control the light-emitting units (22) to provide a predetermined image (M), the predetermined image (M) provided by the light-emitting units (22) is presented on the appearance decorative shell (11) through the micron-level through openings (110);
wherein, when the signal control module (3) is configured to control the light-emitting units (22) to provide a predetermined light source (L), the predetermined light source (L) provided by the light-emitting units (22) is presented on the appearance decorative shell (11) through the micron-level through openings (110).

9. A method of manufacturing a hidden display device (P), **characterized by** comprising:
providing an appearance decorative structure (1) including an appearance decorative shell (11), wherein the appearance decorative shell (11) has a plurality of micron-level through openings (110) arranged in a predetermined shape;
providing a light-emitting module (2) includes a plurality of light-emitting units (22) arranged in a predetermined shape, wherein the light-emitting module (2) is electrically connected to a signal control module (3);
installing the light-emitting module (2) inside the appearance decorative structure (1) so as to cover the light-emitting module (2) through the appearance decorative structure (1); and
performing an alignment step so as to respectively align the light-emitting units (22) with the micron-level through openings (110);
wherein a maximum diameter (D) of each of the micron-level through openings (110) is between 5 µm and 200 µm, and a minimum distance (G) between any two adjacent ones of the micron-level through openings (110) is between 50 µm and 100 µm;
wherein, when the signal control module (3) is configured to control the light-emitting units (22) to provide a predetermined image (M), the predetermined image (M) provided by the light-emitting units (22) is presented on the appearance decorative shell (11) through the micron-level through openings (110);
wherein, when the signal control module (3) is configured to control the light-emitting units (22) to provide a predetermined light source (L), the predetermined light source (L) provided by the light-emitting units (22) is presented on the appearance decorative shell (11) through the micron-level through openings (110).

10. The method of manufacturing the hidden display device (P) according to claim 9, wherein, each of the micron-level through openings (110) is a laser penetration hole formed by laser processing, and the maximum diameter (D) of each of the micron-level through openings (110) is between any two positive integers between greater than 5 µm and less than 200 µm, and the minimum distance (G) of each of the micron-level through openings (110) between any two adjacent micron-level through openings (110) is between any two positive integers between greater than 50 µm and less than 100 µm.

11. The method of manufacturing the hidden display device (P) according to claim 10,
wherein the light-emitting units (22) are in contact with or not in contact with the appearance decorative structure (1), and each of the light-emitting units (22) includes a micro LED chip (22C) or a plurality of micro LED chips (22C);
wherein, when each of the light-emitting units (22) includes the micro LED chips (22C), the micro LED chips (22C) of each of the light-emitting units (22) include a red micro LED chip (22R) for providing a red light source, a green micro LED chip (22G) for providing a green light source, and a blue micro LED chip (22B) for providing a blue light source, and the red micro LED chip (22R), the green micro LED chip (22G) and the blue micro LED chip (22B) cooperate with each other to form an image pixel of the predetermined image (M);
wherein each of the light-emitting units (22) has a light-emitting surface (2200), and the light-emitting surface (2200) of each of the light-emitting units (22) is disposed inside or outside a corresponding one of the micron-level through openings (110);
wherein the light-emitting module (2) includes a plurality of opaque structures (23), and each of the opaque structures (23) is disposed between two adjacent ones of the light-emitting units (22).

12. The method of manufacturing the hidden display device (P) according to claim 11,
wherein the hidden display device (P) further includes a light sensing module (24) including a plurality of light sensing elements (240) electrically connected to the signal control module (3), and the light sensing elements (240) respectively correspond to the light-emitting units (22) or respectively correspond to some of the light-emitting units (22), for identifying a fingerprint image of the user;
wherein the appearance decorative shell (11) is configured as an exterior shell or an interior decoration of a car (C).

13. The method of manufacturing the hidden display device (P) according to claim 12,
wherein, when the appearance decorative shell (11) is configured as the exterior shell of the car (C), the predetermined light source (L) provided by the light-emitting units (22) is applied to an exterior of the car (C) as a rear vehicle light (S5) configured for providing a warning light source;
wherein, when the appearance decorative shell (11) is configured as the interior decoration of the car (C), the predetermined light source (L) provided by the light-emitting units (22) is applied to an interior of the car (C) as a vehicle lighting lamp (S4) configured for providing an illumination light source;
wherein, when the appearance decorative shell (11) is configured as the interior shell of the car (C), the predetermined image (M) provided by the light-emitting units (22) is applied to an A-pillar structure (S1) located inside the car (C) for presenting an external scene located behind the A-pillar structure (S 1) on a surface of the A-pillar structure (S1);
wherein, when the appearance decorative shell (11) is configured as the interior decoration of the car (C), the predetermined image (M) provided by the light-emitting units (22) is applied to an interior of the car (C) as a vehicle instrument panel (S2) configured for providing an information image, thereby providing relevant instrument panel information to the user;
wherein, when the appearance decorative shell (11) is configured as the interior decoration of the car (C), the predetermined image (M) provided by the light-emitting units (22) is applied to the interior of the car (C) as a vehicle display (S3) configured for providing an information image, thereby providing relevant audio and video information to the user.

14. The method of manufacturing the hidden display device (P) according to claim 9, wherein the predetermined image (M) or the predetermined light source (L) is generated by the light-emitting units (22) that are turned on sequentially within a predetermined period.

15. The method of manufacturing the hidden display device (P) according to claim 9, wherein, when the signal control module (3) is configured to completely turn off the light-emitting units (22), a user cannot identify the micron-level through openings (110) of the appearance decorative shell (11) with his or her naked eyes, so that the appearance decorative shell (11) is presented to the user in a hole-free appearance.
